# EUROPEAN PATENT SPECIFICATION

(11) **EP 1 757 712 B1**
(45) Date of publication and mention of the grant of the patent: **04.08.2010**
(21) Application number: 05719882.2
(22) Date of filing: 03.03.2005
(51) Int. Cl.: C23C 14/34, C04B 35/50, G11B 7/24, G11B 7/26

(54) **SPUTTERING TARGET, OPTICAL INFORMATION RECORDING MEDIUM AND METHOD FOR PRODUCING SAME**
SPUTTERTARGET, OPTISCHES INFORMATIONSAUFZEICHNUNGSMEDIUM UND HERSTELLUNGSVERFAHREN DAFÜR
CIBLE DE PULVÉRISATION CATHODIQUE, SUPPORT D"ENREGISTREMENT D"INFORMATIONS OPTIQUES ET PROCEDE DE FABRICATION DE CELUI-CI

(30) Priority: 09.06.2004 JP 2004171205
(43) Date of publication of application: 28.02.2007
(73) Proprietor: Nippon Mining & Metals Co., Ltd., Minato-ku Tokyo 105-0001 (JP)
(72) Inventor: TAKAMI, H., Isohara Fact. of Nikko Mat. Co.,Ltd., Kitaibaraki-shi, Ibaraki 3191535 (JP); YAHAGI, M., Isohara Factory of Nikko Mat. Co.,Ltd., Kitaibaraki-shi, Ibaraki 3191535 (JP)
(74) Representative: Hoarton, Lloyd Douglas Charles
(86) International application number: PCT/JP2005/003578
(87) International publication number: WO 2005/121393

(56) References cited:
- EP-A1- 1 418 575
- JP-A- 6 032 617
- JP-A- 2003 166 052
- JP-A- 2003 166 052
- JP-A- 2004 263 273
- US-A- 5 458 941
- US-A1- 2001 023 006
- US-A1- 2001 044 000
- US-A1- 2003 068 461

## Description

### TECHNICAL FIELD

The present invention relates to a thin film for an optical information recording medium (especially used as a protective film) that has stable film amorphous nature, is superior in adhesiveness and mechanical properties with the recording layer, has a high transmission factor, and is composed with a non-sulfide system, whereby the deterioration of the adjacent reflective layer and recording layer can be suppressed. The present invention also relates to a manufacturing method of such a thin film, and a sputtering target for use therein.

### BACKGROUND ART

Conventionally, ZnS-SiO₂ generally and primarily used as a protective layer of a phase change optical information recording medium has superior characteristics such as in optical characteristics, heat characteristics, and adhesiveness with the recording layer, and is being widely used.

Nevertheless, rewritable DVDs in the present day as represented by Blu-ray discs are strongly demanded of more write cycles, greater capacity, and faster recording.

As one reason for deterioration in the write cycles of an optical information recording medium, there is the diffusion of a sulfur constituent from the ZnS-SiO₂ to the recording layer material disposed in between the protective layers formed from ZnS-SiO₂.

Further, although pure Ag or Ag alloy having high thermal conduction properties with a high reflection ratio is being used as the reflective layer material for realizing high capacity and high-speed recording, this kind of reflective layer is also disposed to come in contact with the protective layer material of ZnS-SiO₂.

Therefore, in this case also, as a result of diffusion of the sulfur constituent from the ZnS-SiO₂, the pure Ag or Ag alloy reflective layer material is subject to corrosive degradation, and would cause the characteristic degradation in the reflection ratio of the optical information recording medium.

As a measure for preventing the diffusion of such sulfur constituent, attempts have been made to provide an intermediate layer having nitrides or carbides as its primary component between the reflective layer and protective layer, and between the recording layer and protective layer. Nevertheless, this results in an increased number of layers, and there is a problem in that that throughput will deteriorate and costs will increase.

In order to overcome the foregoing problems, there is a pressing need to substitute the material with an oxide material that does not contain sulfides in the protective layer material, or discover a material having optical characteristics and amorphous stability that are equivalent to or better than ZnS-SiO₂.

In light of the above, an oxide protective layer material, a transparent conductive material and on optical thin film have been proposed (refer to Patent Documents 1 to 3).

However, Patent Documents 1 to 3 have a problem in that they contain areas that are inferior in optical characteristics and amorphous nature.
[Patent Document 1] Japanese Patent Laid-Open Publication No. H01-317167
[Patent Document 2] Japanese Patent Laid-Open Publication No. 2000-90745
[Patent Document 3] Japanese Patent Laid-Open Publication No. 2003-166052

### SUMMARY OF THE INVENTION

An object of the present invention is to provide a thin film for an optical information recording medium (especially used as a protective film) that has stable film amorphous nature, is superior in adhesiveness and mechanical properties with the recording layer, has a high transmission factor, and is composed with a non-sulfide system, whereby the deterioration of the adjacent reflective layer and recording layer can be suppressed. The present invention also provides a manufacturing method of such a thin film, and a sputtering target for use therein. As a result, the present invention is able to improve the rewriting characteristics of the optical information recording medium.

In order to overcome the foregoing problems, as a result of intense study, the present inventors discovered that, by substituting the conventional protective layer material ZnS-SiO₂ with an oxide material presented below that does not contain sulfides, it is possible to ensure optical characteristics and amorphous stability that are equivalent to or better than ZnS-SiO₂ while improving the rewriting characteristics of the optical information recording medium.

According to the invention there is provided sputtering target comprised of 10 to 60 mol% of Y₂O₃, 10 to 40 mol% of Al₂O₃, and 30 to 80 mol% of SiO₂.

Preferably the relative density is 95% or higher.

The present invention further provides an optical information recording medium with a structure including a thin film formed by sputtering using a sputtering target according to the invention.

The invention also provides a method of manufacturing an optical information recording medium in which a recording layer or a reflective layer is formed and in which a thin film is formed adjacent to the recording layer or the reflective layer by sputtering using a sputtering target according to the invention. Also the invention provides the aforementioned optical information recording medium itself.

By substituting the protective layer material ZnS-SiO₂ with an oxide material that does not contain sulfides, it is possible to suppress the deterioration of the adjacent reflective layer and recording layer caused by sulfur, and to provide a thin film for an optical information recording medium (especially used as a protective film) that has superior characteristics such as having optical characteristics and amorphous stability that are equivalent to or better than ZnS-SiO₂, being superior in adhesiveness and mechanical properties with the recording layer, and having a high transmission factor, as well as a manufacturing method of such a thin film, and a sputtering target for use therein.

Further, by using this material, a superior effect is yielded in that it is possible to improve the rewriting characteristics of the optical information recording medium. In particular, since it is possible to improve the transmission factor of shorter wavelengths, this material can be suitably used as a protective layer material for a blue laser phase-change recording medium.

### BEST MODE FOR CARRYING OUT THE INVENTION

The sputtering target of the present invention is comprised of a material having Y₂O₃, Al₂O₃ and SiO₂ as its primary components. SiO₂, which is a glass-forming oxide, stabilizes the amorphous material. In order to obtain this effect, it is desirable that the SiO₂ content is 30mol% or more. Nevertheless, if the SiO₂ content exceeds 80mol%, there is a problem in that the optical characteristics (refractive index) will become inferior, and it is desirable to make the upper limit 80mol% in order to obtain favorable characteristics.

The addition of Al₂O₃ has the effect of lowering the sintering temperature. By lowering the sintering temperature, it is possible to increase the density and realize stable manufacture. In order to achieve this effect, it is desirable to make the Al₂O₃ content 10mol% or more. Nevertheless, the addition of large amounts of Al₂O₃ will deteriorate the amorphous nature and cause the thermal conductivity to become too great, and, therefore, it is desirable to make the Al₂O₃ content 40mol% or less. The remainder is Y₂O₃; that is, the Y₂O₃ content is 10 to 60mol%.

Thereby, it is possible to make the relative density of the sputtering target to be 95% or higher, and manufacture a stable and high-density sputtering target.

The sputtering target of the present invention can be used to form a thin film, which is a part of an optical information recording medium structure. Further, the sputtering target of the present invention can be used to form a thin film, which is a part of an optical information recording medium structure, and is disposed adjacent to a recording layer or a reflective layer.

This material has stable optical characteristics and amorphous nature of the film, and is suitable as a protective layer of a phase-change optical recording medium. Radio frequency sputtering is used for the deposition.

Since this material has stable amorphous nature and is able to improve the transmission factor as described above, it is suitable as a protective layer material for a phase change recording medium or a blue laser phase change recording medium with a fast rewriting speed.

Further, the sputtering target of the present invention is able to achieve a relative density of 95% or higher. The improvement in density yields an effect of improving the uniformity of the sputtered film and inhibiting the generation of particles during sputtering.

An optical information recording medium can be provided as a thin film in forming a part of an optical information recording medium structure by using the sputtering target described above.

Further, an optical information recording medium that forms a part of the optical information recording medium structure as a thin film, and that is disposed adjacent to a recording layer or a reflective layer by using the foregoing sputtering target can be formed.

Moreover, the thin film formed using the sputtering target of the present invention forms a part of the optical information recording medium structure and is disposed adjacent to the recording layer or reflective layer, but as described above, since ZnS is not used, there is no contamination by S, there is no diffusion of the sulfur constituent to the recording layer material disposed between the protective layers, and there is a significant effect in that the deterioration of the recording layer can be prevented thereby.

Further, when using pure Ag or Ag alloy having high thermal conduction properties at a high reflection ratio as adjacent reflective layers for realizing high capacity and high-speed recording, diffusion of the sulfur constituent to such adjacent reflective layers will not occur, and a superior effect is yielded in that the cause of the reflective layer material being subject to corrosive degradation and causing characteristic degradation in the reflection ratio of the optical information recording medium can be cleared out.

The sputtering target of the present invention can be manufactured by subjecting the oxide powder of the respective constituent elements, in which the average grain size is 5µm or less, to pressureless sintering or high temperature pressure sintering. It is thereby possible to obtain a sputtering target having a relative density of 95% or higher.

In such a case, it is desirable to calcinate the oxide powder having yttrium oxide as its primary component at a temperature of 1000 to 1400°C before sintering. After this calcination, the resultant powder is pulverized to 3µm or less and used as the raw material for sintering.

In the present invention, the addition of Al₂O₃ has a significant effect. As described above, by adding Al₂O₃, a superior effect is yielded in that it is possible to lower the sintering temperature.

In a two component system of Y₂O₃-SiO₂, although the optical characteristics and amorphous nature are favorable, in certain cases it is necessary to raise the temperature to 1700°C or higher in order to increase the density sufficiently, and there is a problem in that stable manufacture is difficult. The present invention is able to lower the sintering temperature to 1600°C or lower, and a significant effect is obtained in that optical characteristics and amorphous nature could be satisfied with high density.

Further, by using the sputtering target of the present invention, a significant effect is yielded in that it is possible to improve the productivity, obtain a high-quality material, and stably manufacture an optical recording medium having an optical disk protective film at low costs.

Improvement in the density of the sputtering target of the present invention reduces holes and miniaturizes crystal grains, and enables the sputtered face of the target to become uniform and smooth. As a result, a significant result is yielded in that particles and nodules generated during sputtering can be reduced, the target life can be extended, and the mass productivity can be improved with minimal variation in the quality.

### Examples

Examples and Comparative Examples of the present invention are now explained. These Examples are merely illustrative, and the present invention shall in no way be limited thereby. In other words, the present invention shall only be limited by the scope of the present invention, and shall include the various modifications other than the Examples of this invention.

### (Examples 1 to 4)

SiO₂ powder, Y₂O₃ powder and Al₂O₃ powder equivalent of 4N and 5µm or less were prepared, and these powders were mixed to achieve the composition shown in Table 1, subject to wet blending, dried, and thereafter calcinated at 1100°C. Further, after subjecting the calcinated powder to wet pulverization up to an average grain size equivalent to 1µm, a binder was added and this was granulated with a spray dryer. This granulated powder was subject to cold pressure forming, thereafter subject to pressureless sintering under oxygen atmosphere (flow) at 1200 to 1600°C, and this sintered material was formed into a target with machining process.

The sintering temperature of Examples 1 to 4 was 1400°C, 1550°C, 1250°C, and 1400°C, respectively. Incidentally, roughly the same sintering results were obtained with the sintering temperature within the foregoing temperature range.

**[Table 1]**

| Examples | Composition Y₂O₃:Al₂O₃:SiO₂ | T/P Density | Transmission Factor 405nm (%) | Refractive Index 405nm | Amorphous Nature *1 |
|---|---|---|---|---|---|
| Example 1 | 35:20:45 | 98 | 95 | 1.8 | ○ |
| Example 2 | 45:20:35 | 96 | 96 | 1.9 | ○ |
| Example 3 | 15:20:65 | 99 | 96 | 1.7 | ○ |
| Example 4 | 20:35:45 | 96 | 96 | 1.8 | ○ |
| Comparative Example 1 | 20:65:15 | 97 | 93 | 1.8 | × |
| Comparative Example 2 | 5: 5:90 | 94 | 98 | 1.5 | ○ |
| Comparative Example 3 | 85:5:10 | 75 | 98 | 2.1 | □ |
| Comparative Example 4 | ZnS-20molSiO₂ | 98 | 80 | 2.3 | ○ |

Amorphous nature was represented with the maximum peak strength against an undeposited glass substrate in a range of 2θ = 20-60° in the XRD measurement of the deposition sample subject to anneal processing (600°C x 30min, Ar atmosphere). Further, o represents 1.0 to 1.5, □ represents 1.5 to 2.0, and x represents 2.0 or more.

The foregoing 6-inch φ size target subject to finish processing was used to perform sputtering. The sputtering conditions were RF sputtering, sputtering power of 1000W, and Ar gas pressure of 0.5Pa, and deposition was performed at a target film thickness of 1500Å.

Results of the measured transmission factor (wavelength 405nm)%, refractive index (wavelength 405n m), and amorphous nature (represented with the maximum peak strength against an undeposited glass substrate in a range of 2θ = 20-60° in the XRD measurement (Cu-Kα, 40kV, 30mA) of the deposition sample subject to anneal processing (600°C x 30min, Ar atmosphere)) are collectively shown in Table 1.

As a result of the above, the sputtering target of Examples 1 to 4 achieved a relative density of 95% or higher, and stable RF sputtering could be performed.

Further, the transmission factor of the sputtered film achieved 95 to 96% (405nm), the refractive index was 1.7 to 1.9, no specific crystal peak could be observed, and possessed a stable amorphous nature (1.0 to 1.5).

Since the targets of the Examples do not use ZnS, there is no characteristic degradation in the optical information recording medium caused by the diffusion or contamination of sulfur. Further, in comparison to the Comparative Examples described later, the transmission factor, refractive index, and amorphous stability all showed favorable numerical values.

### (Comparative Examples 1 to 4)

As shown in Table 1, materials having components and compositions of raw material powder that are different from the conditions of the present invention were prepared, and, particularly in Comparative Example 4, ZnS raw material powder was prepared, the sintering temperature was set to be 1500°C to 1800°C, and targets were prepared with these materials under the same conditions as the Examples, and such targets were used to form a sputtered film. The sintering temperature for Comparative Examples 1 to 4 was 1650°C, 1550°C, 1750°C, and 1000°C (via hot pressing), respectively.

The results are similarly shown in Table 1.

With respect to the components and compositions of the Comparative Examples that deviate from the composition ratio of the present invention; for instance regarding Comparative Example 1, since it contained too much Al₂O₃ at 65mol%, the amorphous nature showed inferior results.

With Comparative Example 2, since it contained insufficient amounts of Y₂O₃ and Al₂O₃, and contained too much SiO₂, it was out of balance and the refractive index deteriorated below standard.

With Comparative Example 3, since it contained too much Y₂O₃ and contained insufficient amounts of SiO₂, it was out of balance and sufficient density could not be achieved, and the sputtering characteristics showed inferior results.

With Comparative Example 4, although the refractive index was high and the density was high, since it contained large amounts of ZnS, it was a material with a risk of being contaminated by sulfur, and the transmission factor also showed inferior results.

### INDUSTRIALAPPLICABILITY

Since the thin film formed by using a sputtering target of the present invention forms a part of the structure of the optical information recording medium and does not use ZnS, it yields a significant effect in that diffusion of the sulfur constituent to the recording layer material will not occur, and deterioration of the recording layer can be prevented thereby. Further, when using pure Ag or Ag alloy having high thermal conduction properties at a high reflection ratio as adjacent reflective layers, diffusion of the sulfur constituent to such reflective layers will not occur, and a superior effect is yielded in that the cause of the reflective layer being subject to corrosive degradation and causing characteristic degradation can be cleared out.

Further, in addition to the amorphous nature becoming stabilized, the target will be provided with conductivity, sintering with a relatively low temperature will be enabled, and the target can thereby be manufactured stably. Moreover, since it is possible to make the relative density a high density of 95% or higher, stable RF sputtering is enabled. In addition, there is a significant effect in that the controllability of sputtering can be facilitated, and the sputtering efficiency can also be improved. Further still, there is significant effect in that it is possible to reduce the particles (dust) or nodules arising during sputtering upon performing deposition, improve the mass productivity with little variation in quality, and stably manufacture an optical recording medium having an optical disk protective film at low costs.

## Claims

1. A sputtering target comprised of 10 to 60 mol% of Y₂O₃, 10 to 40 mol% of Al₂O₃, and 30 to 80 mol% of SiO₂.

2. The sputtering target according to claim 1 or claim 2, wherein the relative density is 95% or higher.

3. An optical information recording medium with a structure including a thin film formed by sputtering using a sputtering target according to claim 1 or claim 2.

4. An optical information recording medium comprising a recording layer or a reflective layer and a thin film disposed adjacent to the recording layer or the reflective layer, said thin film having been formed by sputtering using a sputtering target according to claim 1 or claim 2.

5. A method of manufacturing an optical information recording medium in which a recording layer or a reflective layer is formed and in which a thin film is formed adjacent to the recording layer or the reflective layer by sputtering using a sputtering target according to claim 1 or claim 2.

## Patentansprüche

1. Sputtertarget, das aus 10 bis 60 Mol-% Y₂O₃, 10 bis 40 Mol-% Al₂O₃ und 30 bis 80 Mol-% SiO₂ besteht.

2. Sputtertarget nach Anspruch 1 oder Anspruch 2, wobei die relative Dichte mindestens 95% beträgt.

3. Optisches Aufzeichnungsmedium mit einem Aufbau, der eine Dünnschicht beinhaltet, die durch Sputtern unter Verwendung eines Sputtertargets nach Anspruch 1 oder Anspruch 2 gebildet wurde.

4. Optisches Aufzeichnungsmedium mit einer Aufzeichnungsschicht oder einer reflektierenden Schicht und einer Dünnschicht, die benachbart der Aufzeichnungsschicht oder der reflektierenden Schicht angeordnet ist, wobei die Dünnschicht durch Sputtern unter Verwendung eines Sputtertargets nach Anspruch 1 oder Anspruch 2 gebildet wurde.

5. Verfahren zur Herstellung eines optischen Aufzeichnungsmediums, in dem eine Aufzeichnungsschicht oder eine reflektierende Schicht ausgebildet ist und in dem eine Dünnschicht benachbart der Aufzeichnungsschicht oder der reflektierenden Schicht durch Sputtern unter Verwendung eines Sputtertargets nach Anspruch 1 oder Anspruch 2 ausgebildet ist.

## Revendications

1. Une cible de pulvérisation composée de 10 à 60 mol% d'Y₂0₃, de 10 à 40 mol% d'Al₂0₃ et de 30 à 80 mol% de Si0_{2.}

2. La cible de pulvérisation conformément à la revendication 1 ou 2, dans laquelle la densité relative est de 95 % ou plus.

3. Un support d'enregistrement d'informations optique avec une structure comprenant un film mince formé par pulvérisation à l'aide d'une cible de pulvérisation conformément à la revendication 1 ou 2.

4. Un support d'enregistrement d'informations optique comprenant une couche d'enregistrement ou une couche réflectrice et un film mince disposé à côté de la couche d'enregistrement ou de la couche réflectrice, le film mince ayant été formé par pulvérisation à l'aide d'une cible de pulvérisation conformément à la revendication 1 ou 2.

5. Une méthode de fabrication d'un support d'enregistrement d'informations optique dans laquelle une couche d'enregistrement ou une couche réflectrice est formée et dans laquelle un film mince est formé à côté de la couche d'enregistrement ou de la couche réflectrice par pulvérisation à l'aide d'une cible de pulvérisation conformément à la revendication 1 ou 2.
